# EUROPEAN PATENT SPECIFICATION

(11) **EP 1 369 320 B1**
(45) Date of publication and mention of the grant of the patent: **02.04.2008**
(21) Application number: 03011145.4
(22) Date of filing: 23.05.2003
(51) Int. Cl.: B60R 22/44, B60R 22/46, G01R 31/34

(54) **Failure diagnostic system for seat belt retractor**
Fehlerdiagnosesystem für einen Sicherheitsgurtretraktor
Système de diagnostic de défaillance pour un rétracteur de ceinture de sécurité

(30) Priority: 05.06.2002 JP 2002164547
(43) Date of publication of application: 10.12.2003
(73) Proprietor: TAKATA CORPORATION, Minato-ku, Tokyo 106-8510 (JP)
(72) Inventor: Aoki, Hiroshi, Minato-ku, Tokyo 106-8510 (JP); Kitazawa, Kenji, Minato-ku, Tokyo 106-8510 (JP)
(74) Representative: Banzer, Hans-Jörg

(56) References cited:
- GB-A- 2 335 890

## Description

### [Industrial Field of the Invention]

The present invention relates to a diagnostic system for detecting a failure of a seat belt retractor installed in a vehicle such as an automobile and, more particularly, to a failure diagnostic system for a seat belt retractor of a type provided with a motor for rotating a spool around which a webbing is wound.

### [Related Art]

As well known in the art, a seat belt retractor includes a webbing to be unwound to extend along the body of an occupant sitting in a vehicle seat and, in the event of a vehicle collision, locks the webbing from being unwound so as to restrain the occupant.

Among such seat belt retractors, there is a motorized seat belt retractor in which a motor is used for driving a webbing take-up spool. There are various types of motorized seat belt retractors, such as a type in which the operation of unwinding and winding the webbing is wholly conducted by the motor and a type in which only pretensioning operation (the operation of taking-up the slack of the webbing in a collision or collision prediction) is conducted by the motor. It should be noted that the present invention can be adopted to any type of seat belt retractors.

GB-A-2 335 890 discloses a seatbelt system providing powered retraction and protraction in which a failure of the retraction is detected when the current of the retraction motor exceeds predetermined values for a predetermined amount of time.

GB-A-2335890, considered as closest prior art, shows a failure diagnostic system for detecting a failure of a seat belt retractor having a motor for rotating a webbing take-up spool, comprising: an energization means for supplying driving current or voltage to the motor for a predetermined short period of time; a means for detecting current or voltage of wire-winding of the motor; and a means for determining a failure of the motor based on the current or voltage.

### [Problems to be resolved by the Invention]

It is an object of the present invention to provide a failure diagnostic system for a seat belt retractor which can reliably detect a failure of a motor of the seat belt retractor while the occupant feels no or little discomfort.

### [Means to Solve the Problems]

According to the present invention this object is achieved by a failure diagnostic system as defined in claim 1. The dependent claims define preferred and advantageous embodiments of the invention. The failure diagnostic system for a seat belt retractor of the present invention is a system for diagnosing a failure of a seat belt retractor having a motor for rotating a webbing take-up spool, which comprises: an energization means for supplying driving current or voltage to the motor for a predetermined short period of time upon a diagnosis command signal; a means for detecting current or voltage of wire-winding of the motor; and a means for determining a failure based on the current or voltage.

In the failure diagnostic system of the present invention, the motor is energized for a short period of time (preferably 100 mSec. or less) and current or voltage is detected so as to determine a failure based on the current or voltage. Therefore, the wound or unwound amount of the webbing due to the driving of the motor for the diagnosis is so small that, even when an occupant wears the seat belt, the occupant does not feel any change in tension of the webbing, thus preventing the occupant from feeling discomfort.

In the present invention, since the failure diagnosis is conducted by energizing the motor for a short period of time, the diagnosis can be conducted when a vehicle is in a predetermined operational state, thereby detecting a failure early or in advance.

For example, the "predetermined operational state" is the operation of turning on an ignition switch, the operation of latching a tongue to a buckle, or the operation of unlatching the tongue from the buckle.

The failure diagnostic system of the present invention may keep the suspension of the diagnostic operation when the buckle is in the latched state. In this structure, when the webbing touches the occupant's body, the diagnosis is not executed. Therefore, the occupant never feels any discomfort.

According to the present invention, the rotational direction of the motor for the diagnosis may be the webbing unwinding direction. The webbing slightly slacks relative to the occupant during the diagnosis so that the occupant does not feel any discomfort.

According to the present invention, the failure diagnostic system may put brake on the motor by establishing the conduction between both terminals of the motor after the end of diagnosis. This securely prevents the webbing from excessively slacking or, on the contrary, from excessively tightening the occupant's body.

According to the present invention, the failure diagnostic system may return the wound amount of the webbing to the state prior to the diagnosis by rotating the motor in the reverse direction after the end of diagnosis. This enables the webbing to automatically return to such a length that the occupant feels comfortable.

According to the present invention, the failure diagnostic system may retry the diagnosis predetermined times when the result of the first diagnosis indicates abnormal condition. This can improve the accuracy of failure diagnosis. For the retry, the failure diagnostic system may change the power supplying condition from the energization means to increase the driving force of the motor for the retry. For example, the motor is driven to rotate at low torque for the first diagnosis and the torque is set to be higher step by step after the second diagnosis.

Since small current/voltage is supplied to the motor, the driving force of the motor for the diagnosis is small and the operational speed of the motor is low, whereby the operational noise generated from the transmission or the motor can be small. Therefore, the occupant does not notice the noise, thereby preventing the occupant from feeling discomfort.

According to the present invention, the motor rotation detecting means may comprise sequence, in conjunction with the motor driving control means, for temporally making the wire-winding of the motor to be high impedance after the wire-winding of the motor is energized at low impedance and a means for detecting induced voltage (induced current) of the wire-winding of the motor in synchronization with the sequence. Based on the magnitude of the induced voltage and its polarity, it is determined whether the motor rotates or not, which polarity the motor rotates, or how speed the motor rotates. Since the induced voltage (current) is increased in proportion to increase in rotational speed of the rotor, a large voltage is generated by making high impedance, thereby facilitating the determination.

The motor rotation detecting means may comprise a means, in conjunction with the motor driving control means, for detecting variation with time in current (or mean current in a short distance) in the wire-winding of the motor. Based on the magnitude of the driving current and its polarity, it is determined whether the motor rotates or not, which polarity the motor rotates, or how speed the motor rotates. Since the current decreases according to the rotation of the rotor, the rotation can be detected while the motor is driven.

The failure diagnostic system may conduct the diagnosis by oscillating the rotor, not rotating the rotor in one direction, (by repeating normal rotation and reverse rotation for very short periods of time). In this case, the cycle of reverse rotation, rotation detection, and normal rotation can be repeated for a short period so as to increase the oscillation, thereby improving the reliability in rotation detection.

### [Brief Explanation of the drawings]

FIG. 1 is a block diagram showing a failure diagnostic system for a seat belt retractor according to an embodiment.
FIG. 2 is a circuit diagram of the failure diagnostic system for a seat belt retractor according to the embodiment.
FIG. 3 is a timing chart of the failure diagnostic system for a seat belt retractor according to the embodiment.
FIG. 4 is a chart for explaining the operation of a motor.
FIG. 5 is a wave form chart of induced voltage.
FIG. 6 is a flow chart showing an example of controlling operation.
FIG. 7 is a current wave form chart showing another diagnosis example.

### [Embodiments for carrying out the Invention]

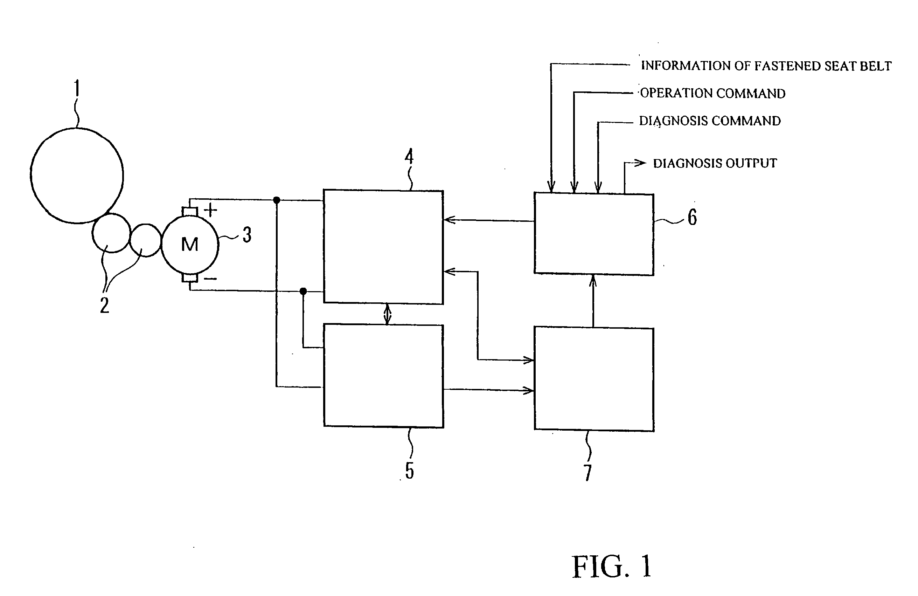

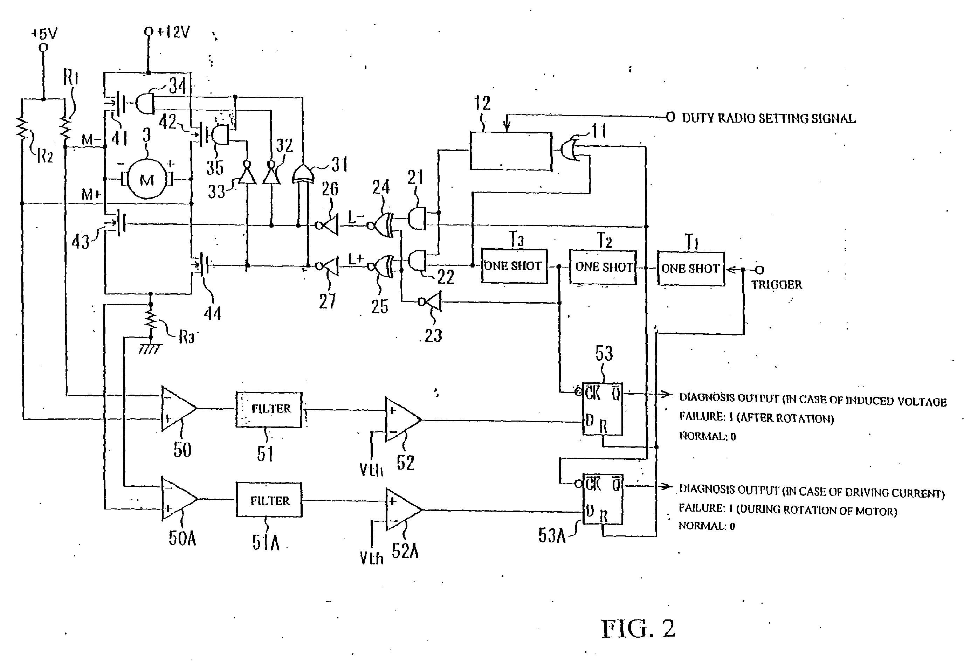

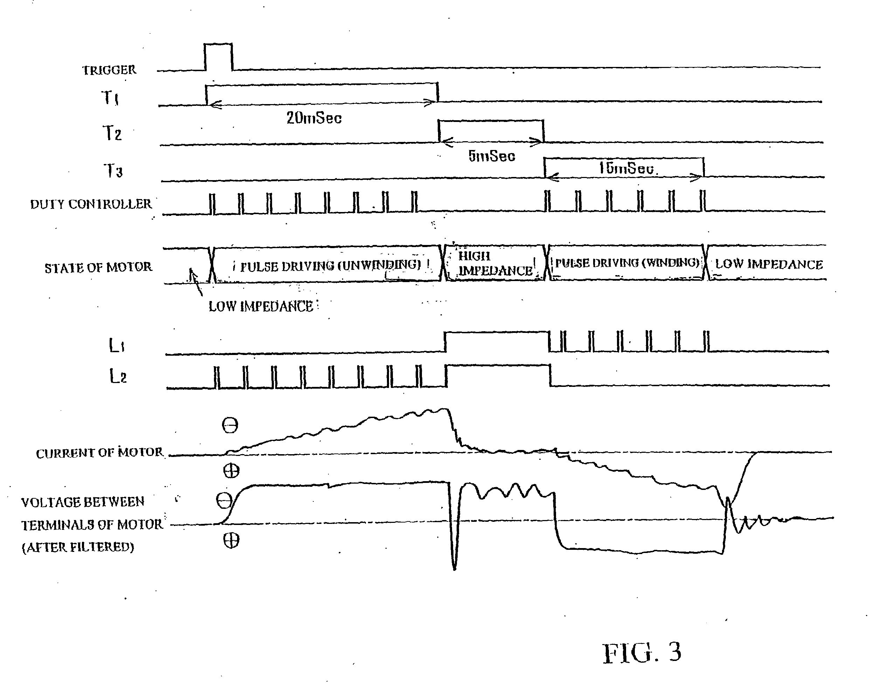

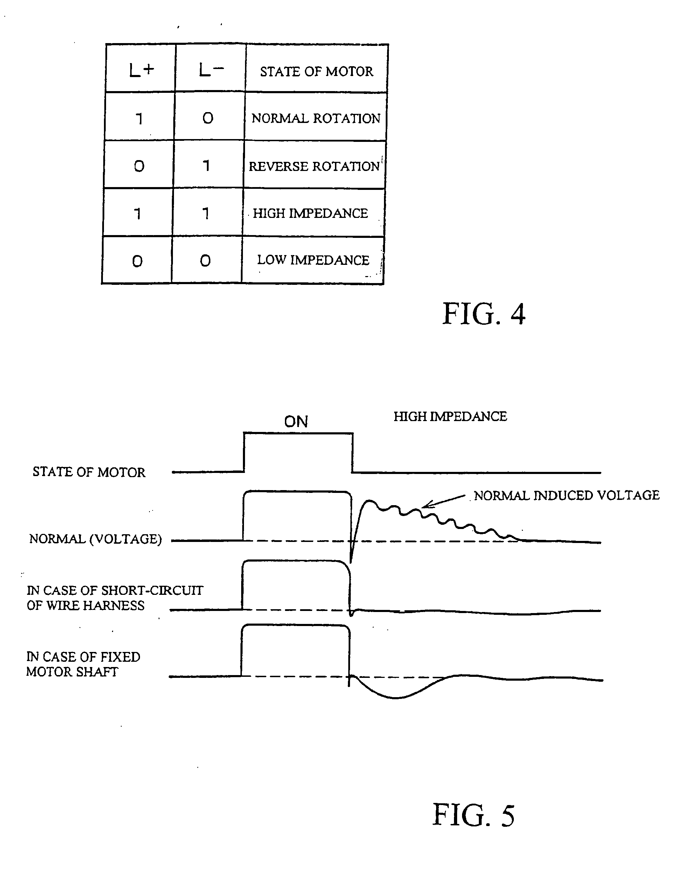

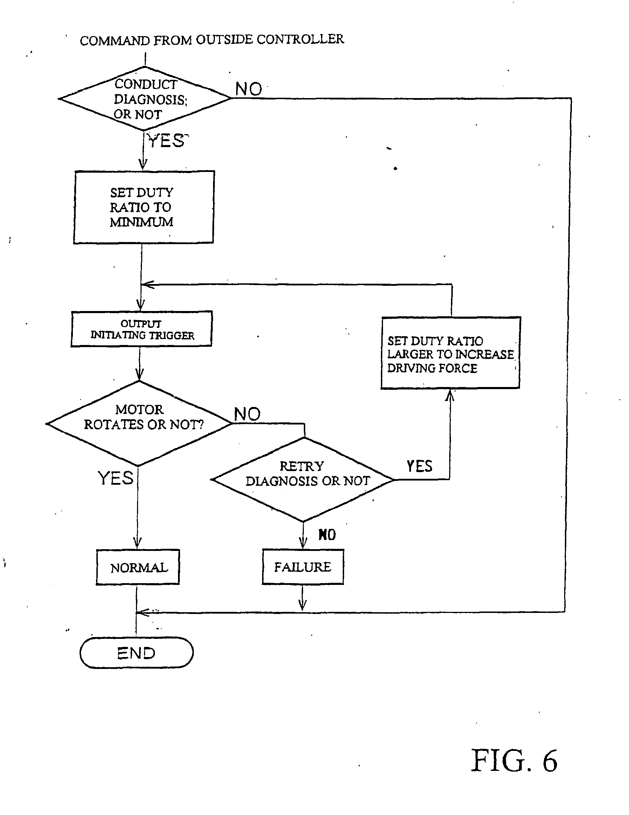

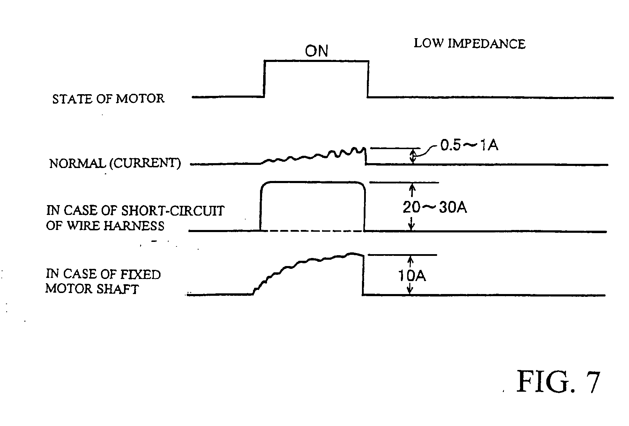

Hereinafter, embodiments will be described with reference to attached drawings. FIG. 1 is a block diagram showing a failure diagnostic system for a seat belt retractor according to an embodiment, FIG. 2 is a circuit diagram of the failure diagnostic system for a seat belt retractor according to the embodiment, FIG. 3 is a timing chart of the failure diagnostic system for a seat belt retractor according to the embodiment, FIG. 4 is a chart for explaining the operation of a motor, FIG. 5 is a wave form chart of induced voltage, FIG. 6 is a flow chart showing an example of controlling operation, and FIG. 7 is a current wave form chart showing another diagnosis example.

As shown in FIG. 1, a motor 3 is connected to a webbing take-up spool 1 of a seat belt retractor via a clutch mechanism 2. Though the motor 3 is designed to be used only for pretensioning in this embodiment, the present invention is not limited thereto as mentioned above.

The clutch mechanism 2 comprises gears to be meshed by driving force of the motor 3 when the motor 3 rotates (the direction may be either of the normal rotation or the reverse rotation). Such a gear-type clutch mechanism is well known in the art, as disclosed in Japanese Patent Unexamined Publication Nos. 2001-347922, 2001-347923, and 2002-104135.

The motor 3 is driven according to a motor-driving control means 4 to which an operational command or a diagnosis command is given through an input/output port 6.

Current or voltage induced by the motor 3 after the stop of the driving is detected by a motor rotation detecting means 5. The detected data are supplied to a failure determination means 7 in order to conduct failure diagnosis. The result of failure diagnosis is outputted through the input/output port 6.

The circuit construction of the motor-driving control means 4, the motor rotation detecting means, and the failure determination means 7 will be described with reference to FIG. 2 and FIG. 3.

Diagnosis command signal is inputted as a trigger signal to a one-shot circuit T₁ from the input/output port 6. The output signal T₁ of the one-shot circuit T₁ is 1 for a predetermined period of time (e.g. 20 mSec.). According to the fall (1 → 0) in the signal T₁ of the one-shot circuit, the output of a one-shot circuit T₂ is 1 for a predetermined period of time (e.g. 5 mSec.). According to the fall in the signal T₂, the output of a one-shot circuit T₃ is 1 for a predetermined period of time (e.g. 15 mSec.).

Logical sum (i.e. "OR") of the signals T₁, T₃ is inputted to a duty controller 12 through an OR gate 11. The duty controller 12 outputs, at a constant frequency, pulse signals of a predetermined duty ratio according to a given duty ratio setting signal. The driving force for the diagnosis can be reduced by adjusting the duty ratio of diagnostic operation. Logical product (i.e. "AND") of the output of the duty controller 12 and the signal T₁ is given to an EXNOR gate 24 through an AND gate 21. Inversion signal of the signal T₂ is also given to the EXNOR gate 24 through an inverter 23. Their exclusive OR is a motor driving signal L-.

Logical product of the output of the duty controller 12 and the signal T₃ is given to an EXNOR gate 25 through an AND gate 22. Inversion signal of the signal T₂ is also given to the EXNOR gate 25. Their exclusive OR is a motor driving signal L+.

The respective inversion signals of the signals L- and L+ through inverters 26, 27 are inputted to an EXOR gate 31. The output of the EXOR gate 31 is inputted to AND gates 34 and 35. The output signal of the inverter 26 is inputted to the gate of an enhancement-type FET 43 and also inputted to the aforementioned AND gate 34 through an inverter 32. The output signal of the inverter 27 is inputted to the gate of an enhancement-type FET 44 and also inputted to the aforementioned AND gate 35 through an inverter 33.

The output of the AND gate 34 is inputted to the gate of an enhancement-type FET 41 and the output of the AND gate 35 is inputted to the gate of an enhancement-type FET 42.

The FETs 41 and 42 are connected at the drains thereof to a power source line "+ 12V". The source of the FET 41 is connected to the negative terminal of the motor 3 and also to the drain of the FET 43. The source of the FET 42 is connected to the positive terminal of the motor 3 and also to the drain of the FET 44. The sources of the FETs 43, 44 are connected to ground via a resistor R₃.

Both terminals of the motor 3 are connected to each other via resistors R₁, R₂ and the connecting point between the resistors R₁, R₂ is connected to a bias line "+ 5V". A voltage potential difference between the terminals of the motor 3 is amplified by an operational amplifier 50 and is compared to a threshold voltage value Vₜₕ at a comparator 52 via a filter 51. The output of the comparator 52 is inputted to the D terminal of a D-type flip-flop 53. Inputted to the R terminal of the D-type flip-flop 53 is the aforementioned trigger. Inputted to the clock terminal CK of the flip-flop 53 is the aforementioned signal T₂. Inversion output is outputted as a diagnosis output to the input/output port.

As shown in FIG. 2 and FIG. 4, when L+ is 1 and L- is 0, the FETs 42, 43 are ON and the FETs 41, 44 are OFF so that the motor rotates in the normal direction so as to slightly unwind the webbing. On the other hand, when L+ is 0 and L- is 1, the FETs 42, 43 are OFF and the FETs 41, 44 are ON so that the motor rotates in the reverse direction.

When L+ and L- are both 1, the FETs 41 through 44 are OFF. Hereinafter, this state will be sometimes called "high impedance". When L+ and L- are both 0, only the FETs 43, 44 are ON so as to establish the conduction between both terminals of the motor 3 (hereinafter, this state will be called "low impedance").

As shown in FIG. 3, by giving a trigger signal, the signal T₁ becomes 1 for a predetermined period of time (in this embodiment, 20 mSec.). During this, an L+ signal in plus shape is outputted at a duty ratio set by the duty controller 12 so that the rotor of the motor rotates. After a lapse of 20 mSec., the signal T₁ is turned to 0 and the signal T₂ becomes 1 so that the FETs 41 through 44 are OFF, that is, the motor becomes into the high impedance state. During this, the rotor of the motor 3 continues to rotate by inertia thereof so as to generate induced voltage. A voltage potential difference thus caused is amplified by the operational amplifier 50 and is compared to the threshold value at the comparator 52. When the motor 3 is normal, the voltage as an output of the operational amplifier 50 is higher than the threshold value and the output of the comparator 52 is 1 and the signal 0 (normal signal) is thus outputted from the reversal output terminal of the D-type flip-flop 53.

When there is a failure of the motor 3, for example, in case of short-circuit of the harness of the motor 3 and a case of inability of the rotor to rotate due to fixed shaft of the motor, the electromotive voltage in the high impedance period after stop of energization is so small that the output of the comparator 52 is 0 and the output from the reversal output terminal of the D flip-flop 53 is a signal 1 indicating the failure.

As shown in FIG. 3, the high impedance state comes to an end at the same time of the fall in T₂ and, in turn, T₃ rises to 1. For 15 mSec., this state (L+ is 0 and L-is 1) is maintained. During this, the motor 3 rotates in reverse direction so as to wind up the webbing.

After that, T₃ falls, thus returning to the initial state.

According to the present invention, when the failure is determined by the diagnosis shown in FIG. 1, the failure diagnostic operation may be conducted once or repeated several times. FIG. 6 shows an example of control for diagnosis.

As shown in FIG. 6, as a diagnosis command is inputted from an outside controller, the duty ratio is set to the minimum value in the duty controller 12 and, after that, an operational trigger is given so as to conduct the aforementioned diagnosis. When the result of the diagnosis indicates normal condition, the diagnostic operation is conducted only once and comes to an end (it should be noted that the operation may be conducted several times even in this case.). When the result of the diagnosis indicates failure, the duty ratio is increased to increase the motor torque. In this state, the diagnostic operation is conducted again. As the result still indicates failure even when the duty ratio reaches to the given upper limit after predetermined number of retries, it is conclusively determined that there is a failure. It must be understood that when the result of a retry indicates normal condition, it is determined that it is normal and then no retry is conducted.

Since the duty ratio for the first operation is set to be small, the amount of winding and unwinding the webbing is so small and the noise generated during the operation is also small. Therefore, the diagnosis can be done while the occupant does not feel any discomfort. Instead of changing the duty ratio, the current or voltage for driving the motor may be changed.

The aforementioned failure diagnosis may be conducted, for example, within 10 seconds after the start of ignition. Alternatively, the diagnosis may be conducted when a buckle is latched. On the contrary, the diagnosis may not be conducted when the occupant wears the seat belt and may be conducted any other point of time, for instance, when the buckle is unlatched.

The rotational direction of the motor during the diagnosis may be the webbing unwinding direction just like the aforementioned embodiment and, on the contrary, may be the webbing winding direction. In case of the webbing unwinding direction, the webbing slightly slacks for the unwound amount so that, even when an occupant wears the seat belt, the occupant does not feel any discomfort.

The rotating time period of the motor for the diagnosis imparts the driving force for driving the rotor of the motor to rotate an amount corresponding to one pole of the rotor (in case of motor having five poles, the rotation number is 1/5 or more). The time period is 100 mSec. or less, preferably in a range of 1 to 10 mSec. The rotation number of the motor for the diagnosis is preferably 0.1 to 2 but not limited thereto.

In case of rotating the motor in the webbing unwinding direction, the tension on the belt is not increased so that the rotation number is preferably in a range of 1-20. In case that the clutch mechanism of the spool is connected by the rotation of the motor 3, a function may be provided which returns the clutch into the initial state at the same time of the diagnosis of the motor. To achieve this, the motor 3 is driven to rotate in such a manner as to have a rotation number in a range of 1-5, thereby canceling the clutch mechanism.

According to the present invention, even when the rotational direction is a direction operating the clutch mechanism, the motor may be driven to rotate in such a manner as to have a rotation number in a rage of 0.1-2 within an idle range where power transmission is not achieved yet. Accordingly, the diagnosis of the motor can be conducted without rotating the spool.

After the rotation of the motor detection on the diagnotic operation is completed, the state may be set to the low impedance state where the FETs 43, 44 are ON. This puts brake on the motor.

Though the motor is a commonly used DC motor in the aforementioned embodiment, the motor is not limited thereto and may be a DC brushless motor or a step motor.

In the present invention, the diagnosis is allowed during energization not after stop of energization. In this case, as shown in FIG. 2, Voltage at both terminals of the resistor R₃ is compared at a comparator 52A through an operational amplifier 50A and a filter 51A. According to the result of the comparator 52A, a diagnostic output is outputted from a flip-flop 53A. The resistor R₃ is preferably in a range of 0.1-0.01 Ω. FIG. 7 shows an example of the diagnostic operation during energization.

### [Effects of the Invention]

As described in the above, the present invention can provide a failure diagnostic system for a seat belt retractor which can reliably detect a failure of a motor of the seat belt retractor while the occupant feels no or little discomfort.

## Claims

1. A failure diagnostic system for detecting a failure of a seat belt retractor having a motor for rotating a webbing take-up spool, comprising:
an energization means for supplying driving current or voltage to the motor (3) for a predetermined short period of time upon a diagnosis command signal;
a means (5) for detecting current or voltage of wire-winding of the motor (3); and
a means (7) for determining a failure of the motor based on the current or voltage.

2. A failure diagnostic system as claimed in claim 1, further comprising: a state detecting means for detecting a predetermined operational state of a vehicle; and a means for initiating a diagnostic operation based on a signal from said state detecting means.

3. A failure diagnostic system as claimed in claim 2, wherein said predetermined operational state is an operation of turning on an ignition switch, an operation of latching a tongue to a buckle, or an operation of unlatching the tongue from the buckle.

4. A failure diagnostic system as claimed in claim 2, wherein said means for initiating the diagnostic operation keeps a suspension of the diagnostic operation when the buckle is in a latched state.

5. A failure diagnostic system as claimed in any one of claims 1 through 4, wherein said energization means supplies driving current or voltage for driving the motor (3) to rotate in a direction of unwinding the webbing from the spool (1).

6. A failure diagnostic system as claimed in any one of claims 1 through 5, wherein a continuous time period of supplying driving power to said energization means is 100 mSec. or less.

7. A failure diagnostic system as claimed in any one of claims 1 through 6, wherein said failure diagnostic system puts brake on the motor (3) by establishing a conduction between both terminals of the motor (3) after the end of diagnosis.

8. A failure diagnostic system as claimed in any one of claims 1 through 7, wherein said failure diagnostic system returns a wound amount of the webbing to a state prior to a diagnosis by rotating the motor (3) in a reverse direction after the end of diagnosis.

9. A failure diagnostic system as claimed in any one of claims 1 through 8, wherein said failure diagnostic system retries the diagnosis predetermined times when a result of a first diagnosis indicates abnormal condition.

10. A failure diagnostic system as claimed in claim 9, wherein said failure diagnostic system changes a power supplying condition from the energization means to increase a driving force of the motor (3) for a retry.

11. A failure diagnostic system as claimed in claim 1, wherein the driving current or voltage supplied from the energization means is smaller than a normal current or voltage for rotating the webbing take-up spool (1).

## Patentansprüche

1. Fehlerdiagnosesystem zum Erfassen eines Fehlers eines Sitzgurtretraktors mit einem Motor zum Drehen einer Gurtbandaufwickelspule, umfassend:
ein Energieversorgungsmittel zum Zuführen eines Antriebsstroms oder einer Spannung zu dem Motor (3) für eine vorbestimmte kurze Zeitdauer aufgrund eines Diagnosebefehlssignals;
ein Mittel (5) zum Erfassen eines Stroms oder einer Spannung einer Leitungswicklung des Motors (3); und
ein Mittel (7) zum Ermitteln eines Fehlers des Motors auf der Grundlage des Stroms oder der Spannung.

2. Fehlerdiagnosesystem nach Anspruch 1, ferner umfassend:
ein Zustandserfassungsmittel zum Erfassen eines vorbestimmten Betriebszustands eines Fahrzeugs; und ein Mittel zum Einleiten eines Diagnosevorgangs auf der Grundlage eines Signals von dem Zustandserfassungsmittel.

3. Fehlerdiagnosesystem nach Anspruch 2, wobei der vorbestimmte Betriebszustand ein Vorgang eines Einschaltens eines Zündschalters, ein Vorgang eines Verriegelns einer Zunge mit einem Gurtschloss oder ein Vorgang eines Entriegelns der Zunge aus dem Gurtschloss ist.

4. Fehlerdiagnosesystem nach Anspruch 2, wobei das Mittel zum Einleiten des Diagnosevorgangs einen Aufschub des Diagnosevorgangs gewährt, wenn sich das Gurtschloss in einem verriegelten Zustand befindet.

5. Fehlerdiagnosesystem nach einem der Ansprüche 1-4, wobei das Energieversorgungsmittel den Antriebsstrom oder die Spannung zum Antreiben des Motors (3) zuführt, um sich in einer Richtung eines Abwickelns des Gurtbandes von der Spule (1) zu drehen.

6. Fehlerdiagnosesystem nach einem der Ansprüche 1-5, wobei eine durchgängige Zeitdauer eines Zuführens einer Antriebskraft zu dem Energieversorgungsmittel 100 ms oder weniger beträgt.

7. Fehlerdiagnosesystem nach einem der Ansprüche 1-6, wobei das Fehlerdiagnosesystem ein Bremsen des Motors (3) durch Einrichten einer Verbindung zwischen beiden Anschlüssen des Motors (3) nach dem Ende der Diagnose vornimmt.

8. Fehlerdiagnosesystem nach einem der Ansprüche 1-7, wobei das Fehlerdiagnosesystem einen Wicklungsbetrag des Gurtbands durch Drehen des Motors (3) in eine umgekehrte Richtung nach dem Ende der Diagnose auf einen Zustand von vor einer Diagnose zurückbringt.

9. Fehlerdiagnosesystem nach einem der Ansprüche 1-8, wobei das Fehlerdiagnosesystem die Diagnose eine vorbestimmte Anzahl von Malen erneut versucht, wenn ein Ergebnis einer ersten Diagnose einen ungewöhnlichen Zustand anzeigt.

10. Fehlerdiagnosesystem nach Anspruch 9, wobei das Fehlerdiagnosesystem einen Energiezuführungszustand von dem Energieversorgungsmittel ändert, um eine Antriebskraft des Motors (3) für eine Wiederholung zu erhöhen.

11. Fehlerdiagnosesystem nach Anspruch 1, wobei der Antriebsstrom oder die Spannung, welche von dem Energieversorgungsmittel zugeführt wird, kleiner als ein normaler Strom oder eine normale Spannung zum Drehen der Gurtbandaufwickelspule (1) ist.

## Revendications

1. Système de diagnostic de défaillance pour détecter une défaillance d'un enrouleur ou rétracteur de ceinture de sécurité ayant un moteur pour faire tourner une bobine de tension de sangle, comprenant,
des moyens de fourniture d'énergie pour fournir un courant ou une tension d'entraînement au moteur (3) pendant une brève période de temps prédéterminée sur un signal de commande de diagnostic ;
des moyens (5) pour détecter un courant ou une tension d'enroulement de sangle du moteur (3) ; et
des moyens (7) pour déterminer une défaillance du moteur sur la base du courant ou de la tension.

2. Système de diagnostic de défaillance selon la revendication 1, comprenant en outre : des moyens de détection d'état pour détecter un état opérationnel prédéterminé d'un véhicule ; et des moyens pour déclencher une opération de diagnostic sur la base d'un signal provenant desdits moyens de détection d'état.

3. Système de diagnostic de défaillance selon la revendication 2, dans lequel ledit état opérationnel prédéterminé est une opération d'allumage d'un commutateur d'allumage, une opération de verrouillage d'une languette à une boucle, ou une opération de déverrouillage de la languette de la boucle.

4. Système de diagnostic de défaillance selon la revendication 2, dans lequel lesdits moyens pour déclencher l'opération de diagnostic maintiennent une suspension de l'opération de diagnostic lorsque la boucle est dans un état verrouillé.

5. Système de diagnostic de défaillance selon l'une quelconque des revendications 1 à 4, dans lequel lesdits moyens de fourniture d'énergie fournissent un courant ou une tension d'entraînement pour entraîner le moteur (3) afin qu'il fasse tourner dans une direction de déroulement la sangle de la bobine (1).

6. Système de diagnostic de défaillance selon l'une quelconque des revendications 1 à 5, dans lequel la période de temps continue de fourniture d'énergie motrice auxdits moyens de fourniture d'énergie est de 100 ms ou moins.

7. Système de diagnostic de défaillance selon l'une quelconque des revendications 1 à 6, dans lequel ledit système de diagnostic de défaillance freine le moteur (3) en établissant une conduction entre les deux bornes du moteur (3) après la fin du diagnostic.

8. Système de diagnostic de défaillance selon l'une quelconque des revendications 1 à 7, dans lequel ledit système de diagnostic de défaillance renvoie une quantité d'enroulement de la sangle à un état antérieur à un diagnostic en faisant tourner le moteur (3) dans une direction inverse après la fin du diagnostic.

9. Système de diagnostic de défaillance selon l'une quelconque des revendications 1 à 8, dans lequel ledit système de diagnostic de défaillance relance le diagnostic un nombre de fois prédéterminé lorsque le résultat d'un premier diagnostic indique un état anormal.

10. Système de diagnostic de défaillance selon la revendication 9, dans lequel ledit système de diagnostic de défaillance modifie un état de fourniture d'énergie à partir des moyens de fourniture d'énergie pour accroître la force motrice du moteur (3) pour un nouvel essai.

11. Système de diagnostic de défaillance selon la revendication 1, dans lequel le courant ou la tension d'entraînement fourni(e) par les moyens de fourniture d'énergie est inférieur(e) au courant ou à la tension normale pour faire tourner la bobine de tension de sangle (1).
